# EUROPÄISCHE PATENTSCHRIFT

(11) **EP 1 322 967 B1**
(45) Veröffentlichungstag und Bekanntmachung des Hinweises auf die Patenterteilung: **18.05.2005**
(21) Anmeldenummer: 01983514.9
(22) Anmeldetag: 28.09.2001
(51) Int. Cl.: G01R 1/073, G01R 31/28

(54) **MODUL FÜR EINE PRÜFVORRICHTUNG ZUM TESTEN VON LEITERPLATTEN**
MODULE FOR A TESTING DEVICE FOR TESTING PRINTED CIRCUIT BOARDS
MODULE DESTINE A UN DISPOSITIF DE TEST POUR LE TEST DE CARTES A CIRCUITS IMPRIMES

(30) Priorität: 04.10.2000 DE 10049301
(43) Veröffentlichungstag der Anmeldung: 02.07.2003
(73) Patentinhaber: atg test systems GmbH & Co. KG, 97877 Wertheim (DE)
(72) Erfinder: ROTHAUG, Uwe, 97828 Marktheidenfeld (DE); BRANDT, Peter, 97082 Würzburg (DE); GOLDSCHMITT, Volker, 97877 Wertheim-Dörlesberg (DE); SCHUHMACHER, Eckart, 97877 Wertheim (DE)
(74) Vertreter: Ganahl, Bernhard
(86) Internationale Anmeldenummer: PCT/EP2001/011265
(87) Internationale Veröffentlichungsnummer: WO 2002/031516

(56) Entgegenhaltungen:
- EP-A- 0 818 684
- WO-A-00/26681
- DE-U- 8 806 064
- US-A- 4 674 006

## Beschreibung

Die vorliegende Erfindung betrifft ein Modul für eine Prüfvorrichtung zum Testen von Leiterplatten sowie eine Vorrichtung zum Prüfen von Leiterplatten.

Vorrichtungen zum Prüfen von elektrischen Leiterplatten sind bspw. aus der US 3,564,408 bzw. der US 4,417,204 bekannt. Diese Vorrichtungen weisen eine Kontaktplatte auf, an der Prüfstifte in einem Grundraster angeordnet sind. Die Prüfstifte sind über lange Kabel mit einer Prüfschaltung verbunden. Die zu prüfenden Leiterplatten werden auf die Prüfplatte aufgelegt, wobei ein Adapter zwischen der Leiterplatte und der Prüfplatte angeordnet sein kann, so dass zwischen jedem Prüfpunkt der zu prüfenden Leiterplatte und einem Prüfstift ein elektrischer Kontakt hergestellt wird.

Ausgehend von dieser Art von Prüfvorrichtungen wurden modular aufgebaute Prüfvorrichtungen entwickelt, wie sie in den Patenten DE 32 40 916 C2 und DE 33 40 180 C1 beschrieben sind. Diese Art von Prüfvorrichtungen weisen eine Grundplatte auf, auf der vertikal angeordnete Module lagern, die jeweils einen Teil der elektronischen Prüfschaltung umfassen und an ihrem oberen Ende vertikal ausgerichtete Prüfstifte aufweisen. In einer Prüfvorrichtung werden mehrere derartige Module nebeneinander angeordnet, wobei die Anordnung der Prüfstifte ein die Kontaktplatte ersetzendes Kontaktfeld bildet. Für einen guten Zusammenhalt der Module kann eine Lochplatte auf die Prüfstifte aufgesetzt werden, wobei jeder Prüfstift ein Loch in der Lochplatte durchsetzt und so in seiner Lage fixiert ist.

Dieser modulare Aufbau des Kontaktfeldes hat sich sehr bewährt und in der Praxis durchgesetzt. Ein wesentlicher Vorteil dieses modularen Aufbaus ist, dass der Kontaktdruck, der beim Prüfen einer Leiterplatte angelegt wird, über die Module an die Grundplatte weitergeleitet wird.

Aus dem Gebrauchsmuster DE 88 06 064 U1 ist eine weitere Prüfvorrichtung bekannt, bei der das Kontaktfeld modular ausgebildet ist. Diese Module sind streifenförmig ausgebildet mit zum Beispiel je vier Reihen quadratischer Pads bzw. Kontaktflächen. Es ist hierin offenbart, dass die Pads in einem Raster mit einem Rastermaß von beispielsweise 0,5 - 2 mm angeordnet sind. Diese Module mit einer derart dichten Anordnung von Pads haben sich in der Praxis nicht durchgesetzt, da sie zum einen wegen der hohen Anzahl von Kontaktstellen nur von einer sehr grossen und damit teuren Auswertelektronik ausgelesen werden konnten und zum anderen hat die im Gebrauchsmuster DE 88 06 064 beschriebene Ausführungsform mit einer vertikal gestellten Leiterplatte, an deren Stirnseite unmittelbar die Kontaktflächen ausgebildet sind, in der Serienproduktion erhebliche Probleme bereitet.

Aus der EP 875 767 geht eine Prüfvorrichtung hervor, die eine Anzahl von Testanschlüssen aufweist, wobei Leiterplattentestpunkte der zu testenden Leiterplatte mit einem Testanschluß über eine elektrische Verbindung in Kontakt stehen.

Die Auswerteelektronik ist elektrisch mit einem Grundraster verbunden, wobei auf dem Grundraster ein Adapter und/oder ein Translator lagert, auf welche eine zu testende Leiterplatte aufgelegt werden kann. Der Adapter und/oder Translator stellt einen elektrischen Kontakt von auf der Leiterplatte befindlichen Leiterplattentestpunkten zu Kontaktstellen des Grundrasters her.

Diese Prüfvorrichtung zeichnet sich dadurch aus, dass zumindest zwei Kontaktstellen elektrisch miteinander verbunden sind. Insbesondere sind bei dieser Vorrichtung jeweils mehrere Kontaktstellen entlang je einem geradlinigen Scankanal elektrisch miteinander verbunden. Die einzelnen Scankanäle sind mit einer Auswerteelektronik elektrisch verbunden. Da jeder Scankanal mit mehreren Kontaktstellen verbunden ist, ist die Anzahl der Einheiten der Auswerteelektronik im Vergleich zu der Auswerteelektronik einer vergleichbaren Prüfvorrichtung erheblich vermindert und der gesamte Aufbau der Prüfvorrichtung gestattet sich sehr einfach.

Obwohl bei dieser Prüfvorrichtung mehrere Testpunkte mit einem einzigen Scankanal elektrisch verbunden sind, hat sich überraschenderweise gezeigt, dass bei den allermeisten Anwendungen keine Doppelbelegungen der Scankanäle vorliegen bzw. derartige Doppelbelegungen mit einer gezielten Zuordnung der Leiterplattentestpunkte zu den Kontaktstellen der Prüfvorrichtung ausgeschlossen werden können. Dies wird dadurch erzielt, dass mit dieser bekannten Vorrichtung mit vergleichbar einfachen technischem Aufwand eine hohe Dichte an Kontaktstellen geschaffen wird.

Aus der EP 0 222 036 B1 ist ein elektronisches Leiterplattenprüfgerät bekannt, bei dem das Grundraster durch Überlagern zweier regelmäßiger Raster mit einem Rasterabstand von 2,54 mm dargestellt wird, wobei die beiden Raster zueinander versetzt angeordnet sind. Diese Rasteranordnung wird als Double-Density bezeichnet, da sie die doppelte Kontaktstellendichte gegenüber herkömmlichen Grundrastern aufweist.

Der Erfindung liegt die Aufgabe zugrunde, ein Modul für eine Prüfvorrichtung zu schaffen, das kostengünstig herstellbar ist und dennoch zur Ausbildung eines Grundrasters mit höherer Kontaktstellendichte als das bekannte Double-Density-Raster geeignet ist.

Die Erfindung weist zur Lösung dieser Aufgabe die im Anspruch 1 angegebenen Merkmale auf. Vorteilhafte Ausgestaltungen hiervon sind in den weiteren Ansprüchen angegeben.

Das erfindungsgemäße Modul für eine Prüfvorrichtung zum Testen von Leiterplatten, umfasst:
- Mehrere in einem streifenförmigen Abschnitt einer Testebene angeordnete Kontaktstellen, und
- eine Elektronikeinheit, die zumindest einen Teil einer Auswerteelektronik zum Auswerten von Prüfsignalen bildet, und die Elektronikeinheit ist im Bereich unterhalb des streifenförmigen Abschnitt angeordnet und bildet mit den Kontaktstellen eine bauliche Einheit, wobei
die Kontaktstellen in einem Raster mit einem Rasterabstand von nicht mehr als 2 mm angeordnet sind, und
zumindest zwei Kontaktstellen elektrisch miteinander verbunden sind und die elektrisch verbundenen Kontaktstellen jeweils mit einem Eingang der Elektronikeinheit verbunden sind.

Die erfindungsgemäßen Module weisen eine größerer Kontaktstellendichte als bisher bekannte Module auf, wobei durch das elektrische Verbinden mehrerer Kontaktstellen die kostenintensive Elektronikeinheit klein gehalten wird.

Bei einer paarweisen Verbindung von Leiterplattentestpunkten ist bei einer doppelten Kontaktstellendichte im Vergleich zu bekannten Grundrastern die gleiche Kapazität an Auswerteelektronik vorzusehen. Die Leiterplattentestpunktdichte kann somit ohne erhebliche Zusatzkosten verdoppelt werden.

Der modulare Aufbau dieser Prüfvorrichtung ist fertigungstechnisch sehr vorteilhaft, da jeweils nur kleine Abschnitte dieses Grundrasters mit hoher Kontaktstellendichte hergestellt werden müssen. Würde ein derartiges Grundraster aus großflächigen Segmenten hergestellt werden, würde dies aufgrund der hohen Kontaktstellendichte zu erheblichen fertigungstechnischen Problemen führen.

Die vorstehende Aufgabe, die Merkmale und Vorteile nach der vorliegenden Erfindung können unter Berücksichtigung der folgenden, detaillierten Beschreibung der bevorzugten Ausführungsform der vorliegenden Erfindung und unter Bezugnahme auf die zugehörigen Zeichnungen besser verstanden werden.

Die Erfindung wird im folgenden anhand der Zeichnungen näher erläutert. Diese zeigen schematisch sehr vereinfacht in:
- Fig. 1: ein Modul in perspektivischer Ansicht,
- Fig. 2: eine Draufsicht auf das Modul, und
- Fig. 3: einen vergrößerten Ausschnitt aus Fig. 2 und
- Fig. 4: ein weiteres Modul in perspektivischer Ansicht und
- Fig. 5: einen Bereich einer Prüfvorrichtung mit einem Modul, einer Vollrasterkassette, einem Adapter und einer zu prüfenden Leiterplatte im Querschnitt.

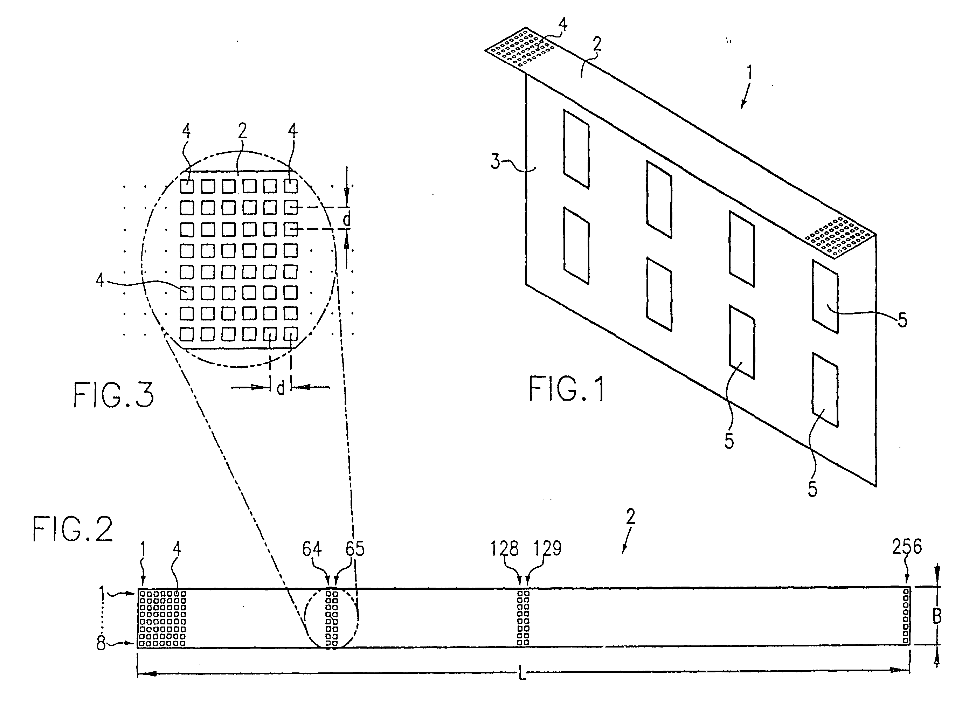

Fig. 1 zeigt schematisch grob vereinfacht ein erfindungsgemäßes Modul 1 mit einer streifenförmigen Leiterplatte 2, an der im rechten Winkel eine Leiterplatte 3 befestigt ist. Die streifenförmige Leiterplatte 2 wird nachfolgend als Grundrasterstreifen 2 bezeichnet. Dieser weist an seiner Oberseite Kontaktstellen 4 auf, die in einem regelmäßigen Raster angeordnet und als Kontaktflächen, den sogenannten Pads, ausgebildet sind. Zur Vereinfachung der Zeichnungen sind in Fig. 1 und Fig. 2 nicht alle Kontaktstellen dargestellt. An der Leiterplatte 3 sind Elektronikbausteine 5 angeordnet, die zumindest einen Teil einer Auswerteelektronik bilden. Diese Leiterplatte 3 stellt somit eine Elektronikeinheit dar.

Die Kontaktstellen sind in einem quadratischen Raster angeordnet, wobei der Mittenabstand d zwischen zwei benachbarten Kontaktstellen sowohl in X-Richtung als auch in Y-Richtung jeweils 1,27 mm (50 mil) beträgt.

Der Grundrasterstreifen 2 besitzt eine Länge L von 32,512 cm (12,8 inch) und eine Breite B von 1,016 cm (0,4 inch) (Fig. 2). Auf dem Grundrasterstreifen 2 sind die Kontaktstellen 4 in 8 Reihen und 256 Spalten angeordnet. In Fig. 2 sind die einzelnen Reihen und Spalten entsprechend nummeriert. Ein solches Modul besitzt somit 2048 Kontaktstellen.

Im Grundrasterstreifen 2 sind Scankanäle entsprechend den in der EP 875 767 beschriebenen Scankanälen ausgebildet. Diese Scankanäle sind aus elektrischen Leitungen ausgebildet und verlaufen parallel zu den Reihen der Kontaktstellen. Die Grundrasterstreifen bestehen deshalb aus einer mehrlagigen Leiterplatte mit mindestens 20 Lagen und vorzugsweise 30 bis 36 Lagen. Die Scankanäle sind zwischen benachbarten Lagen angeordnet und weisen eine Breite von z.B. 100 µm und einen Mittenabstand von z.B. 110 pm auf. Sie sind gleichmäßig zwischen den einzelnen Lagen verteilt, wobei zum Rand des Grundrasterstreifens ein Abstand von 10 µm bis 50 µm eingehalten wird, um sicherzustellen, dass der Rand zur Einhaltung der notwendigen Präzision gefräst werden kann, ohne dass hierbei ein Scankanal verletzt wird. Die Scankanäle verbinden jeweils Paare von Kontaktstellen, die in einer Reihe um 64 Kontaktstellen voneinander beabstandet sind. Dies bedeutet, dass die Kontaktstelle der 1. Reihe und der 1. Spalte elektrisch mit der Kontaktstelle der 1. Reihe und der 65. Spalte verbunden ist. Entsprechendes gilt für die Kontaktstellen der 2. Spalte und der 66. Spalte usw. Die Kontaktstellen der 129. Spalte sind wiederum mit den Kontaktstellen der 193. Spalte elektrisch verbunden.

Da in dem Bereich zwischen den Spalten 128 und 129 keine elektrische Verbindung mittels der Scankanäle vorgesehen ist, sind aus fertigungstechnischen Gründen die die Scankanäle bildenden Leitungen unterbrochen. Eine Leitung bildet somit zwei Scankanäle. Ein solcher Grundrasterstreifen 2 weist somit 512 Leitungen bzw. 1024 Scankanäle auf.

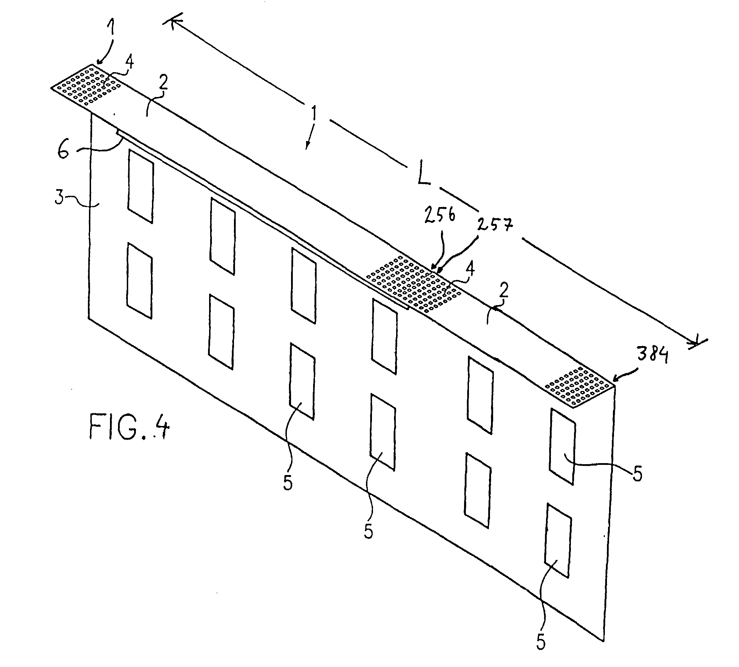

Figur 4 zeigt ein zweites Ausführungsbeispiel der erfindungsgemäßen Module 1, das wiederum ein Grundrasterstreifen 2 aufweist, an dem im rechten Winkel eine Leiterplatte 3 befestigt ist, auf der Elektronikbausteine 5 angeordnet sind.

Der Grundrasterstreifen 2 ist wiederum mit acht Reihen Kontaktstellen 4 versehen. Die Länge L dieses Grundrasterstreifens 2 beträgt ca. 48,77 cm (19,2 inch), d. h., dass dieser Grundrasterstreifen 1,5 mal so lang ist, wie der des ersten Ausführungsbeispiels.

In der Breite B stimmen die Grundrasterstreifen beider Ausführungsbeispiele überein. Auf den Grundrasterstreifen 2 des zweiten Ausführungsbeispiels sind die Kontaktstellen in 348 Spalten angeordnet, so daß insgesamt 3.072 Kontaktstellen 4 vorgesehen sind.

Im Grundrasterstreifen 2 sind wiederum Scankanäle vorgesehen, die bezüglich der Spalten 1 bis 256 identisch zu denen des ersten Ausführungsbeispiels ausgebildet und entsprechend mit den Kontaktstellen 4 des Grundrasterstreifens 2 elektrisch verbunden sind. In dem Bereich zwischen den Spalten 257 und 384 sind wiederum 512 Scankanäle vorgesehen, die wiederum Paare von Kontaktstellen 4 verbinden, die in einer Reihe um 64 Kontaktstellen voneinander beabstandet sind.

Die Scankanäle im Bereich zwischen der 1. und 128. Spalte sind elektrisch mit den Scankanälen im Bereich zwischen der 257. und 384. Spalte elektrisch verbunden. Die hierfür vorgesehenen Verbindungsleitungen 6 sind auf der Leiterplatte 3 angeordnet. In Fig. 4 ist schematisch eine der Verbindungsleitungen 6 dargestellt. Die Verbindungsleitungen 6 sind derart geschaltet, dass jeweils Paare von Kontaktstetlen, des Bereiches zwischen der 1. und 128. Spalte mit Paaren von Kontaktstellen zwischen der 257. und 384. Spalte elektrisch verbunden sind, die in einer Reihe um 256 Kontaktstellen voneinander beabstandet sind. Dies bedeutet, dass die Kontaktsteilen der 1. Reihe und der 1. Spalte elektrisch mit der Kontaktstelle der 1. Reihe und 257. Spalte verbunden ist. Diese Kontaktstellen sind selbstverständlich durch die paarweise Verknüpfung innerhalb der jeweiligen Bereiche auch mit der Kontaktstelle der 1. Reihe und der 65. Spalte sowie der Kontaktstelle der 1. Reihe und der 321. Spalte verbunden. Entsprechendes gilt für die Kontaktstellen der 2. Spalte und der 158. Spalte, u.s.w.

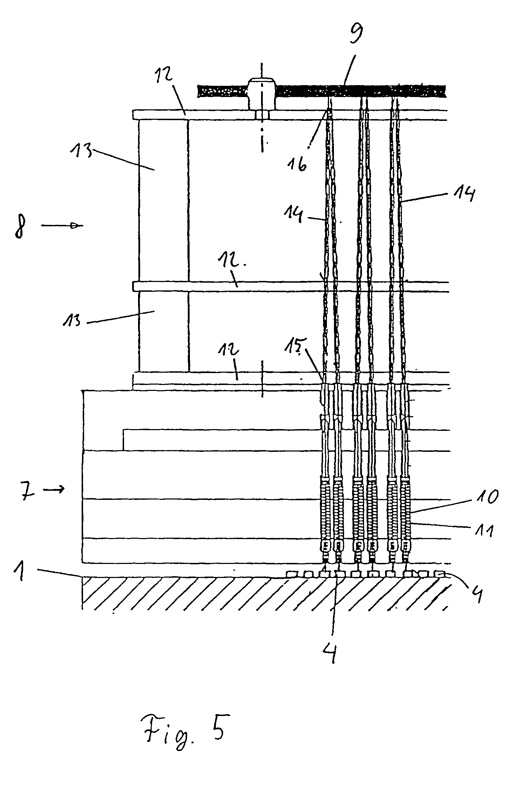

Figur 5 zeigt einen Bereich einer Prüfvorrichtung im Querschnitt mit einer erfindungsgemäßen Modul 1, einer Vollrasterkassette 7, einem Addapter 8 und einer zu prüfenden Leiterplatte 9. Unmittelbar auf den durch die erfindungsgemäßen Module 1 ausgebildeten Grundraster mit den Kontaktstellen 4 liegt die Vollrasterkassette 7 auf. Die Vollrasterkassette 7 weist Kontaktstifte 10 auf, die mit Federelementen 11 versehen sind, so dass die Kontaktstifte 10 elastisch zusammendrückbar ausgebildet sind. Die Kontaktstifte 10 sind in dem Raster der Kontaktstellen 4 angeordnet und auf jeder Kontaktstelle 4 steht ein Kontaktstift 10. Der auf der Vollrasterkassette 7 aufliegende Adapter 8 weist Führungsplatten 12 auf, die von einer Gehäusewand 13 gehalten werden. Die Führungsplatten 12 sind mit Führungsbohrung versehen, in welchen Prüfnadeln 14 lagern. Die unteren Enden 15 der Prüfnadeln 14 sind jeweils im Raster der Kontaktstellen 4 bzw. im Raster der Prüfstifte 11 angeordnet und stehen jeweils mit einem der Prüfstifte 11 in Kontakt. Die Prüfnadeln sind zum Teil schräg im Adapter angeordnet, so dass sie mit ihren oberen Enden 16 an Leiterplattentestpunkten der zu testenden Leiterplatte 9 anliegen. Mit dem Adapter wird somit das regelmäßige Grundraster der Kontaktstellen 4 bzw. der Prüfstifte 11 in die unregelmäßige Anordnung der Leiterplattentestpunkte umgesetzt.

Die Kontaktstifte der in Figur 5 gezeigten Vollrasterkassette sind in vierfacher Dichte (quad-Density) mit einem Rastermaß von 1,27 mm (50 mil) angeordnet. Ein wesentlicher Vorteil der erfindungsgemäßen Module ist, dass auf dem durch die Kontaktstellen 4 der Module 1 ausgebildeten Grundraster auch herkömmliche Vollrasterkassetten aufgesetzt werden können, deren Kontaktstifte lediglich mit einfacher Dichte (Single-Density) bzw. doppelter Dichte (Double-Density) angeordnet werden können. Hierdurch kann ein Benutzer einer Prüfvorrichtung mit den erfindungsgemäßen Modulen bereits vorhandene Vollrasterkassetten und Adapter weiterhin benutzen. Dies stellt einen enormen wirtschaftlichen Vorteil dar, da für einen jeden Leiterplattentyp ein Adapter konstruiert werden muss, was erhebliche Kosten verursacht. Liegt zu einem bestimmten Leiterplattentyp bereits ein Adapter vor, der für eine Prüfvorrichtung mit einem Grundraster in einfacher Dichte oder doppelter Dichte vorgesehen ist, so kann dieser weiterhin auf einer Prüfvorrichtung mit erfindungsgemäßen Modulen, die ein Grundraster mit 4-facher Dichte aufweisen, verwendet werden. Bei Konkurrenzprodukten mit Prüfraster mit 4-facher Dichte ist diese Kompatibilität zu Prüfvorrichtungen mit geringerer Dichte nicht gegeben.

Ein weiterer wesentlicher Vorteil dieser erfindungsgemäßen Module ist, dass die Prüfvorrichtungen, die mit Modulen versehen sind, deren Kontaktstellen lediglich ein Grundraster mit einfacher und doppelter Dichte bilden, einfach durch Austausch der herkömmlichen Module durch erfindungsgemäße Module auf ein Grundraster mit 4-facher Dichte der Kontaktstellen aufgerüstet werden können. Hierbei ist besonders von Vorteil, dass die Kontaktstellen des Grundrasters elektrisch miteinander verbunden sind. Hierdurch ist die Anzahl der notwendigen Eingänge zur Elektronikeinheit wesentlich geringer als die Anzahl der Kontaktstellen. Die Kontaktstellen gemäß dem in Figur 1 gezeigten Ausführungbeispiel sind paarweise verbunden, so das die Anzahl der notwendigen Eingänge zur Elektronikeinheit bei einem Grundraster mit 4-facher Dichte lediglich die Hälfte der Anzahl der Kontaktstellen beträgt, was der Anzahl von Kontaktstellen eines Grundrasters mit doppelter Dichte entspricht. Somit kann ein Modul mit 4-facher Dichte in eine herkömmliche Prüfvorrichtung eingesetzt werden, die für Module mit doppelter Dichte ausgebildet ist. Es ist somit ein Umrüsten von doppelter auf 4-facher Dichte möglich, ohne dass an der Hardware der Prüfvorrichtung und insbesondere der Auswerteelektronik etwas zu verändern ist.

In einer Prüfvorrichtung zum Testen von Leiterplatten werden die Module mit ihren Grundrasterstreifen 2 angrenzend zur Ausbildung eines durchgehenden Grundrasters zusammengesetzt und in der Vorrichtung mit an sich bekannten Mitteln fixiert. Die einzelnen Grundrasterstreifen sind in der Ebene des Grundrasters angeordnet.

Die Erfindung ist oben anhand eines Ausführungsbeispiels beschrieben. Die Erfindung ist selbstverständlich nicht auf dieses konkrete Ausführungsbeispiel begrenzt. Im Rahmen der Erfindung ist es z.B. möglich, einen Teil der Scankanäle oder alle Scankanäle auf der Elektronikeinheit 3 zu realisieren. Die Module können auch mit zusätzlichen Funktionen, wie z.B. federnd ausgebildeten Kontaktelementen ausgebildet sein, die die Kontaktstellen darstellen.

Hinsichtlich vorstehend im einzelnen nicht näher erläuterter Merkmale der Erfindung wird in übrigen ausdrücklich auf die Ansprüche und die Zeichnung verwiesen.

## Patentansprüche

1. Modul für eine Prüfvorrichtung zum Testen von Leiterplatten, umfassend
- mehrere in einem streifenförmigen Abschnitt einer Testebene angeordnete Kontaktstellen (4), und
- eine Elektronikeinheit (3), die zumindest einen Teil einer Auswerteelektronik zum Auswerten von Prüfsignalen bildet, und die Elektronikeinheit (3) ist im Bereich unterhalb des streifenförmigen Abschnitts angeordnet und bildet mit den Kontaktstellen (4) eine bauliche Einheit, wobei
die Kontaktstellen (4) in einem Raster mit einem Rasterabstand von nicht mehr als 2 mm angeordnet sind, wobei zumindest zwei Kontaktstellen (4) elektrisch miteinander verbunden sind und die elektrisch verbundenen Kontaktstellen (4) jeweils mit einem einzigen Eingang der Elektronikeinheit verbunden sind.

2. Modul nach Anspruch 1,
**dadurch gekennzeichnet,**
**dass** die Kontaktstellen (4) paarweise miteinander verbunden sind.

3. Modul nach Anspruch 2,
**dadurch gekennzeichnet,**
**dass** die Kontaktstellen (4) in parallel zur Längserstreckung des Moduls verlaufenden Reihen und quer dazu verlaufenden Spalten angeordnet sind, wobei jede Kontaktstelle mit der um X Kontaktstellen entfernten Kontaktstelle der gleichen Reihe elektrisch verbunden ist, wobei X eine Zahl zwischen 30 und 100 und vorzugsweise zwischen 50 und 80 ist.

4. Modul nach einem der Ansprüche 1 bis 3,
**dadurch gekennzeichnet,**
**dass** die Kontaktstellen (4) auf einer streifenförmigen Leiterplatte (2) ausgebildet sind, und die Elektronikeinheit (3) als mechanisch mit der streifenförmigen Leiterplatte (2) verbundene Leiterplatte dargestellt ist.

5. Modul nach Anspruch 4,
**dadurch gekennzeichnet,**
**dass** die Kontaktstellen (4) mittels in der streifenförmigen Leiterplatte (2) verlaufender Scankanäle verbunden sind.

6. Modul nach Anspruch 5,
**dadurch gekennzeichnet,**
**dass** die Scankanäle durch elektrische Leitungen ausgebildet sind, die sich in Längsrichtung der Leiterplatte (2) erstrecken, wobei die Leiterbahnen unterbrochen sind.

7. Modul nach Anspruch 6,
**dadurch gekennzeichnet,**
**dass** das Modul zumindest drei Bereiche aufweist, zwischen welchen die die Scankanäle darstellenden elektrischen Leitungen jeweils unterbrochen sind, wobei die Scankanäle zweier nicht benachbarter Bereiche mittels Leiterbahnen (6) elektrisch miteinander verbunden sind.

8. Modul nach Anspruch 7,
**dadurch gekennzeichnet,**
**dass** die Leiterbahnen (6) auf der Leiterplatte der elektronischen Einheit (3) ausgebildet sind.

9. Modul nach einem der Ansprüche 1 bis 8,
**dadurch gekennzeichnet,**
**dass** der Rasterabstand zwischen benachbarten Kontaktstellen 1,27 mm (50 mil) beträgt.

10. Vorrichtung zum Prüfen von Leiterplatten mit
mehreren Modulen nach einem der Ansprüche 1 bis 9, die zur Ausbildung eines durchgehenden regelmäßigen Grundrasters mit den die Kontaktelemente aufweisenden streifenförmigen Abschnitten in einer Ebene zueinander angrenzend angeordnet sind.

11. Vorrichtung nach Anspruch 10,
**dadurch gekennzeichnet,**
**dass** zur Kontaktierung von Leiterplattentestpunkten auf dem Grundraster eine Vollrasterkassette (7) und ein Adapter (8) angeordnet sind.

12. Vorrichtung nach Anspruch 11,
**dadurch gekennzeichnet,**
**dass** die Vollrasterkassette Prüfstifte (10) aufweist, die entweder in dem gleichen Raster wie die Kontaktstellen (4) des Grundrasters oder in einem Raster mit geringer Dichte angeordnet sind.

## Claims

1. Module for a test apparatus for the testing of printed circuit boards, comprising:
- several contact points (4) arranged in a strip-shaped section of a test plane, and
- an electronics unit (3) forming at least part of an electronic evaluation unit for the evaluation of test signals, with the electronics unit (3) located in the area beneath the strip-shaped section and forming a structural unit with the contact points (4), wherein
the contact points (4) are arranged in a grid with a grid spacing of no more than 2 mm, wherein at least two contact points (4) are electrically connected to one another, and the electrically connected contact points (4) are each connected to a single input of the electronics unit.

2. Module according to claim 1,
**characterized in that**
the contact points (4) are connected to one another in pairs.

3. Module according to claim 2,
**characterized in that**
the contact points (4) are arranged in rows running parallel to the longitudinal extent of the module and in columns running at right-angles to the former, wherein each contact point is electrically connected to the contact point in the same row which is X contact points away from it, wherein X is a number between 30 and 100 and preferably between 50 and 80.

4. Module according to any of claims 1 to 3,
**characterized in that**
the contact points (4) are formed on a strip-shaped printed circuit board (2), and the electronics unit (3) is in the form of a printed circuit board connected physically to the strip-shaped printed circuit board (2).

5. Module according to claim 4
**characterized in that**
the contact points (4) are connected by means of scanning channels running in the strip-shaped printed circuit board (2).

6. Module according to claim 5,
**characterized in that**
the scanning channels are formed by electrical conductors extending in the longitudinal direction of the printed circuit board (2), wherein the conductor paths are interrupted.

7. Module according to claim 6,
**characterized in that**
the module has at least three areas, between each of which the electrical conductors representing the scanning channels are interrupted, wherein the scanning channels of two non-adjacent areas are electrically connected to one another by means of conductor paths (6).

8. Module according to claim 7
**characterized in that**
the conductor paths (6) are formed on the printed circuit board of the electronics unit (3).

9. Module according to any of claims 1 to 8,
**characterized in that**
the grid spacing between adjacent contact points is 1.27 mm (50 mil).

10. Apparatus for the testing of printed circuit boards with
several modules according to any of claims 1 to 9, which are arranged adjacent to one another in one plane to form a continuous regular basic grid with strip-shaped sections containing the contact elements.

11. Apparatus according to claim 10,
**characterized in that**
a full grid cassette (7) and an adapter (8) are arranged on the basic grid for the contacting of circuit board test points.

12. Apparatus according to claim 11,
**characterized in that**
the full grid cassette has test pins (10) arranged either in the same grid as the contact points (4) of the basic grid or in a grid of lower density.

## Revendications

1. Module pour un dispositif de contrôle pour tester des cartes à circuits imprimés, comprenant :
- plusieurs points de contacts (4) agencés sur un plan de test dans un tronçon en forme de bande ; et
- une unité électronique (3) qui forme au moins une partie d'une unité électronique d'évaluation pour évaluer des signaux de contrôle, et l'unité électronique (3) est agencée dans la région sous le tronçon en forme de bande et forme une unité constructive avec les points de contacts (4), dans lequel :
-- les points de contacts (4) sont agencés dans une trame présentant un pas de trame ne dépassant pas 2 mm ;
-- au moins deux points de contacts (4) sont reliés électriquement l'un à l'autre ; et
-- les points de contacts (4) reliés électriquement sont reliés respectivement à une entrée unique de l'unité électronique.

2. Module selon la revendication 1, **caractérisé en ce que** les points de contacts (4) sont reliés entre eux par paires.

3. Module selon la revendication 2, **caractérisé en ce que** les points de contacts (4) sont agencés dans des rangées s'étendant parallèlement à l'extension longitudinale du module et dans des colonnes s'étendant perpendiculairement à celles-ci, chaque point de contact (4) étant relié électriquement au point de contact éloigné à raison de X points de contacts dans la même rangée, X étant un chiffre compris entre 30 et 100 et de préférence entre 50 et 80.

4. Module selon l'une des revendications 1 à 3, **caractérisé en ce que** les points de contacts (4) sont réalisés sur une carte à circuits imprimés (2) en forme de bande et **en ce que** l'unité électronique (3) est représentée comme une carte à circuits imprimés reliée mécaniquement à la carte à circuits imprimés (2) en forme de bande.

5. Module selon la revendication 4, **caractérisé en ce que** les points de contacts (4) sont reliés au moyen de canaux de balayage s'étendant dans la carte à circuits imprimés (2) en forme de bande.

6. Module selon la revendication 5, **caractérisé en ce que** les canaux de balayage sont réalisés par des lignes électriques qui s'étendent dans la direction longitudinale de la carte à circuits imprimés (2), les pistes conductrices étant interrompues.

7. Module selon la revendication 6, **caractérisé en ce qu'**il présente au moins trois zones entre lesquelles les lignes électriques représentant les canaux de balayage sont interrompues respectivement, les canaux de balayage de deux zones non voisines étant reliés électriquement entre eux au moyen de pistes conductrices (6).

8. Module selon la revendication 7, **caractérisé en ce que** les pistes conductrices (6) sont réalisées sur la carte à circuits imprimés de l'unité électronique (3).

9. Module selon l'une des revendications 1 à 8, **caractérisé en ce que** le pas de trame entre deux points de contacts voisins s'élève à 1,27 mm (50 mils).

10. Dispositif pour contrôler des cartes à circuits imprimés comprenant plusieurs modules selon l'une des revendications 1 à 9, qui sont agencés de manière adjacente les uns aux autres dans un plan pour réaliser une trame de base continue et régulière avec les tronçons en forme de bande présentant les éléments de contact.

11. Dispositif selon la revendication 10, **caractérisé en ce qu'**une cassette de trame pleine (7) et un adaptateur (8) sont agencés pour la mise à contact de points de test de carte à circuits imprimés sur la trame de base.

12. Dispositif selon la revendication 11, **caractérisé en ce que** la cassette de trame pleine présente des pointes de contrôle (10) qui sont agencées soit dans la même trame que les points de contacts (4) de la trame de base soit dans une trame avec une plus faible densité.
